Europäisches Patentamt

European Patent Office

Office européen des brevets

(19)

(11) Veröffentlichungsnummer: **0 410 234 B1**

(12) # EUROPÄISCHE PATENTSCHRIFT

(45) Veröffentlichungstag der Patentschrift: **14.09.94**

(51) Int. Cl.5: **G01R 15/07**

(21) Anmeldenummer: **90113496.5**

(22) Anmeldetag: **14.07.90**

(54) **Verfahren zur Messung eines elektrischen Feldes oder einer elektrischen Spannung und Einrichtung zur Durchführung des Verfahrens.**

(30) Priorität: **22.07.89 DE 3924369**

(43) Veröffentlichungstag der Anmeldung:
**30.01.91 Patentblatt 91/05**

(45) Bekanntmachung des Hinweises auf die
Patenterteilung:
**14.09.94 Patentblatt 94/37**

(84) Benannte Vertragsstaaten:
**BE CH DE FR IT LI SE**

(56) Entgegenhaltungen:
**EP-A- 0 088 419**
**WO-A-89/00701**

**IEEE TRANSACTIONS ON POWER APPARA-
TUS AND SYSTEMS. vol. 99, no. 3, 1980,
NEWYORK US pages 1057 - 1065;
D.C.ERICKSON: "The Use of Fiber Optics for-
Communications, Measurement and Control
within High Voltage Substations"**

**REVUE GENERALE DE L'ELECTRICITE. no. 5,
May 1989, PARIS FR pages 39 - 47;
D.CHATREFOU: "Un combiné optique de mesure courant-tension"**

(73) Patentinhaber: **Asea Brown Boveri Aktiengesellschaft**
**Kallstadter Strasse 1**
**D-68309 Mannheim (DE)**

(72) Erfinder: **Kunz, Heribert**
**Hammweg 27**
**D-7500 Karlsruhe 21 (DE)**
Erfinder: **Schwab, Adolf**
**Brühlstrasse 78**
**D-7500 Karlsruhe 41 (DE)**

(74) Vertreter: **Rupprecht, Klaus, Dipl.-Ing. et al**
**c/o ABB Patent GmbH,**
**Postfach 10 03 51**
**D-68128 Mannheim (DE)**

EP 0 410 234 B1

APPLIED OPTICS. vol. 28, no. 11, 01 June 1989, NEW YORK US pages 2001 - 2011;K.S.LEE: "New compensation method for bulk optical sensors with multiplebirefringences"

PATENT ABSTRACTS OF JAPAN vol. 14, no. 381 (P-1093)(4324) 16 August 1990,(HITACHI) 01 June 1990,

PATENT ABSTRACTS OF JAPAN vol. 13, no. 209 (P-871)(3557) 17 May 1989,& JP-A-126168 (MATSUSHITA ELECTRIC IND.) 27 January 1989,

EP 0 410 234 B1

**Beschreibung**

Die Erfindung betrifft ein Verfahren nach dem Oberbegriff des Anspruches 1 sowie eine Einrichtung zur Durchführung des Verfahrens.

Die Erfindung bezieht sich dabei auf ein Spannungsmeßverfahren bzw. eine Spannungsmeßeinrichtung, bei dem bzw. bei der ein den Pockelseffekt aufweisender Kristall verwendet wird.

Der Pockelseffekt ist ein linear elektrooptischer Effekt, der bei bestimmten einachsigen, natürlich doppelbrechenden Kristallen ohne Symmetriezentrum auftritt. Dabei wird der Kristall - im Prinzip als Dielektrikum zwischen zwei Platten eingefügt, zwischen denen ein elektrisches Feld erzeugt wird. Durch dieses elektrische Feld wird eine feldstärkeabhängige Modulation des Polarisationszustandes der Lichtwelle erzeugt, die mittels einer Auswerteeinheit detektiert werden kann (siehe DE-B-Schwab, Hochspannungstechnik, 2. Auflage, Springer Verlag, Seite 176 ff, insbesondere Seite 177, 178 bis 179, 181 bis 184). Dies kann zur Spannungsmessung insbesondere in Hochspannungsanlagen benutzt werden. Im Gegensatz zu sog. konventionellen Strom- oder Spannungswandlern können mit Meßeinrichtungen, die auf dem Pokkelseffekt basieren, hochfrequente Feld- oder Spannungsänderungen gemessen werden.

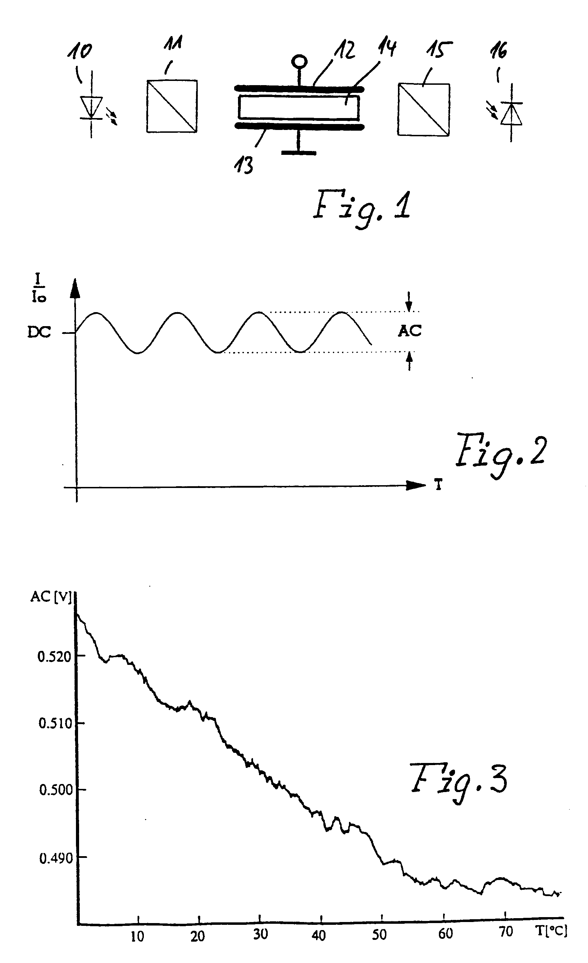

Eine Spannungsmeßeinrichtung, bei der das eingangs genannte Verfahren angewendet werden kann, besteht im Prinzip aus einer monochromatischen Lichtquelle, beispielsweise einem Laser, einer Infrarot-Leuchtdiode oder einer ähnlichen Lichtquelle, deren Licht nacheinander einen Polarisator, einen mit Elektroden versehenen elektrooptischen Kristall und einen weiteren linearen Polarisator, der Analysator genannt wird, passiert, um anschließend auf eine Fotodiode einer Auswerteeinrichtung zu treffen (siehe auch Figur 1).

Ein wesentliches Problem hierbei besteht in der optischen und mechanischen Empfindlichkeit des Kristalls bei Temperaturveränderungen.

Aus der EP-OS 0 083 196 ist bekannt, als elektrooptischen Kristall einen Kristall der Zusammensetzung $Bi_{12}$-$SiO_{20}$ (BSO) oder $Bi_{12}GeO_{20}$ (BGO) zu verwenden, welche Kristallart eine natürliche lineare Doppelbrechung nicht aufweist. Wegen diesen besonderen physikalischen Gegebenheiten erhält man einen im wesentlichen temperaturkompensierten Kristall dadurch, daß man ihn auf eine bestimmte Länge begrenzt; in der speziellen, in der europäischen Offenlegungsschrift beschriebenen Form ist die definierte Kristalllänge ca. 4,66 Millimeter. Diese dort beschriebene Maßnahme ist aber für andere üblicherweise eingesetzte elektrooptische Kristalle, wie z. B. ADP ($NH_4H_2PO_4$), KDP ($KH_2PO_4$), $LiNbO_3$, $LiTaO_3$, Quarz und dgl. wegen der dort existieren natürlichen linearen Doppelbrechung und deren zusätzlicher Temperaturcharakteristik nicht geeignet.

Die in der oben angegebenen Druckschriften beschriebenen Kristalle bzw. Materialien sind keine natürlich vorkommenden Materialien und demgemäß vergleichsweise teuer.

Aus der Literaturstelle 8047 IEEE, Transactions on Power Apparatus and Systems vol. PAS-99 (1980) May/June, No. 3, New York, Seiten 1059 und folgende, ist bekannt, als Sensor einen Kristall zu verwenden, bei dem der Pockelseffekt ausgenutzt wird. Dabei wird der im wesentlichen langgestreckt rechteckig ausgebildete Sensor von polarisiertem Licht in seiner Längsrichtung durchstrahlt und dessen Änderung der Polarisationsrichtung detektiert, wogegen ein zweiter Teilstrahl polarisierten Lichtes senkrecht zu der ersten Durchstrahlungsrichtung durch den Sensor hindurchgeleitet und dessen Änderung der Polarisationsrichtung detektiert wird. Der zweite Teilstrahl wird in einer Temperaturauswerteeinrichtung ausgewertet. Die Aufteilung der Strahlen zur Temperaturkompensation erfolgt vor dem Sensor.

Aus der WO 89/00 701 ist ein elektrischer Stromsensor bekannt geworden, der den Farradayeffekt ausnutzt. Hier wird der aus dem Sensor austretende Lichtstrahl in zwei Teillichtstrahlen aufgeteilt, um die Änderung der Polarisationsebene zu detektieren und Korrekturfaktoren für Doppelbrechungserscheinungen zu erhalten. Eine Temperatursteuerung erfolgt bei dem den Lichtstrahl abstrahlenden Sender.

Quarz, insbesondere $\alpha$-Quarz, welches ein natürlich vorkommendes kristallines Material ist, weist ebenfalls den Pockelseffekt auf und demgemäß bietet es sich an, als Meßelement eines elektrooptischen Spannungswandlers eingesetzt zu werden, siehe Epping: "Potentialfreie elektrooptische Feldstärkenmessung mit Quarzkristallen und ihre Anwendungen in der Hochspannungstechnik", Dissertation an der Universität (TH) Karlsruhe insbesondere Seite 111 ff. In dieser Dissertation sind die elektrooptischen Eigenschaften von $\alpha$-Quarz umfassend dargestellt und auf Seite 111 ff. ist auch eine Spannungsmeßeinrichtung mittels eines $\alpha$-Quarzkristalles beschrieben und dargestellt. Mit dem Problem der Temperaturabhängigkeit hat sich Epping an dieser Stelle nicht beschäftigt.

Die oben angegebenen Temperaturkompensationen bei BGO- oder BGS-Materialien sind bei Quarz nicht anwendbar.

Aufgabe der Erfindung ist es daher, eine Anordnung der eingangs genannten Art anzugeben, bei der als Meßelement ein Quarz verwendet ist und bei der eine ausreichende Kompensation der Temperaturänderun-

3

gen erzeugt wird.

Diese Aufgabe wird erfindungsgemäß gelöst durch die kennzeichnenden Merkmale des Ansprüches 1.

In besonders vorteilhafter Weise werden gemäß den Ansprüchen 2 bis 4 sowohl die statistischen Fehler, die auf Dämfungsvorgänge innerhalb der Meßanordnung zurückzuführen sind, als auch die durch Temperaturänderungen hervorgerufenen Fehler kompensiert.

In besonders vorteilhafter Weise wird als elektrooptischer Kristall Quarz verwendet, obwohl das erfindungsgemäße Verfahren auch bei allen denjenigen Kristallen anwendbar ist, die den Pockelseffekt aufweisen. Quarz aber ist ein natürlich vorkommender Kristall, der demgemäß eine Spannungsmeßeinrichtung gestattet, die preisgünstig herzustellen ist.

Im folgenden sollen kurz die Eigenschaften von Quarz näher erläutert werden (siehe auch oben genannte Dissertation von Epping).

Quarz ist ein optisch einachsiges, anisotropes Medium des trigonalen Kristallsystems der Klasse 32. Es existieren in seinem Inneren für unterschiedliche Raumrichtungen unterschiedliche Brechungsindices, wobei der Kristall sowohl natürliche lineare Doppelbrechung, als auch natürliche optische Aktivität (also Zirkulardoppelbrechung) aufweist. Demgemäß verändert sich der Polarisationszustand von einfallenden, linear polarisiertem Licht nach Verlassen des Quarzes bereits ohne äußeres elektrisches Feld, und aufgrund der im Inneren des Quarzes erzeugten zirkularen Brechung erhält man an der Ausgangsseite schwach elliptisch polarisiertes Licht.

Zu den für die natürliche lineare Doppelbrechung wirksamen Brechungsindices addieren bzw. subtrahieren sich unter Einwirkung einer senkrecht zum Lichtstrahl anliegenden elektrischen Wechselfeldes feldstärkeabhängige Anteile, wodurch eine induzierte lineare Doppelbrechung bewirkt wird, was als sog. transversaler Pockelseffekt bezeichnet wird. Diese zusätzlich induzierte lineare Doppelbrechung bewirkt eine Pendelbewegung des schwach elliptisch polarisierten Lichts um einen Winkel um dessen Ruhelage, die mittels des Analysators und der darauf folgenden Auswerteeinheit detektiert werden kann.

Die Einrichtung ist erfindungsgemäß durch die kennzeichnenden Merkmale der Ansprüche 5 bzw. 6 beschrieben.

Erfindungsgemäß wird also als Analysator ein polarisierender Strahlteilerwürfel verwendet, der das aus dem Kristall austretende Licht in zwei senkrecht zueinander polarisierte Teilstrahlen zerlegt, die zwei getrennten optischen Empfängern zugeführt werden.

Zwar ist eine solche Anordnung im Grundsatz aus der DE-OS 34 04 608 bekanntgeworden. Jedoch verläuft das elektrische Feld in Richtung des Lichtstrahles, siehe Seite 20, Zeile 11 bis 13, und darüberhinaus werden die beiden aus den Austrittsenden des sensorabseitigen Lichtleiters aufgenommenen bzw. abgenommenen Signale nach einer bestimmten Rechenvorschrift zu einem einzigen Signal zusammengefaßt. Damit wird lediglich eine Dämpfungskompensation erreicht, nicht aber eine Temperaturkompensation. Diese wird nämlich durch die besondere Bemessung der elektrooptischen Kristalle erzeugt, mit denen sich die DE-OS 34 04 608 befaßt, nicht aber durch die sensorabseitige Aufteilung des Lichtes in zwei Teilstrahlen. Im übrigen sind Fehler kaum vermeidbar, wenn Änderungen unter anderem in der Lage in einem oder beiden Lichtleitern hinter dem Strahlenteiler auftreten. Es ist daher hier dafür zu sorgen, daß die Lichtwellenleiter insbesondere keine Lageänderung erfahren.

Die beiden Signale sind mit Fehlern zufälliger Natur als Folge von Dämpfungseinflüssen entlang der optischen Übertragungsstrecke behaftet und darüber hinaus weisen sie noch einen systematischen Fehler aufgrund des negativen Temperaturkoeffizienten der sogenannten elektrooptischen Konstanten auf. Die Fehler zufälliger Natur als Folge von Dämpfungseinflüssen entlang der optischen Übertragungsstrecke können durch Vergleich mit einem Sollwert eliminiert werden, wogegen die Signalkorrekturen zur Elliminierung der Temperaturabhängigkeit wie folgt durchzuführen sind:

Das polarisierte Licht weist ein AC- bzw. DC-Signalsanteil auf. Durch die Temperaturänderung ist ein Abwandern der Schwingungsebene des näherungsweise linear polarisierten Lichtes nach Verlassen des Quarzes aus seinem Arbeitspunkt, d. h. aus einem Winkel von $\alpha = 45°$ zu den beiden senkrecht zueinander stehenden Durchlaßrichtungen des Analysators zu beobachten. Dadurch findet keine hälftige Aufteilung der vor dem Analysator vorhandenen Lichtintensität mehr statt und die Differenz $\Delta$ DC der Gleichanteile der beiden Teilstrahlen steht in jedem Zeitpunkt in einem definierten Zusammenhang mit der Temperatur längs des Lichtweges im Kristall, also im Quarzinneren, so daß

$$\Delta \ DC \ = \ f(T).$$

Der Anteil AC, also der Wechselanteil des Signals ist proportional der Änderung des Gleichanteils:

$$AC \ = \ p \cdot \Delta \ DC$$

4

und diese Gleichung weist einen Weg zur Korrektur des Wechselanteils auf.

Demgemäß kann der Quarzkristall mit der erfindungsgemäßen Anordnung untersucht und ein Korrekturfaktor angegeben werden, der für die Auswertung in der Auswerteeinheit zur Verfügung gelangt. Damit lassen sich Meßgenauigkeiten im Promillebereich erreichen.

Im Endeffekt wird die - neue - Erkenntnis ausgenutzt, daß der Sensor als Spannungsmesser und Temperaturfühler wirkt. Das Zusammenbringen der beiden Eigenschaften führt hin zur Erfindung, also zur Schaffung eines Spannungsmeßverfahrens mit einer Korrektur des Temperatureinflusses. Demgemäß könnte das erfindungsgemäße Verfahren auch rein für Temperaturmessung verwendet werden.

Im wesentlichen teilt sich die Anwendung des Verfahrens auf in zwei Teile:

1. Zunächst wird das Verfahren bei konstanter, am Meßelement anstehender Spannung durchgeführt. Aufgrund der erfindungsgemäßen Beziehungen zwischen den Gleich- und Wechselspannungsanteilen der beiden Ausgangssignale ergibt sich ein Meßsignal, das abhängig von der Temperatur ist. Dieses Meßsignal, das der Differenz der beiden Gleichanteile - und die statistischen Fehler korrigiert - entspricht und daß der unterschiedliche Temperaturen unterschiedliche Werte annimmt, entspricht jeweils für jede Temperatur ein als "dritter Korrekturfaktor K" bezeichneter Korrekturfaktor. Die Werte Gleichanteil-Differenz und zugehöriger dritter Korrekturfaktor K werden in einer Tabelle abgespeichert, z. B. in einem in der Auswerteeinheit befindlichen Speicher.

Dies ist durchzuführen, nach dem die Meßeinrichtung gefertigt worden ist, als Eich- oder Justiermaßnahme.

2. Im Betrieb also nach Einbau beispielsweise in eine Schaltanlage wird vor jedem betriebsmäßigen Meßvorgang die Gleichspannungsanteildifferenz bestimmt, damit der dritte Korrekturfaktor aus der - abgespeicherten - Tabelle ermittelt und mit dem Wechselspannungsanteil an einem der beiden Empfänger multipliziert. Hieraus ergibt sich die tatsächliche temperaturkorrigierte sekundäre Wechselspannung.

Obig beschriebenes Verfahren ist ein elektrisches Feld-oder Spannungsmeßverfahren, bei dem die Feld-Spannungseinrichtung quer zur Lichtrichtung verläuft.

Wenn man ein magnetisches Feld parallel zur optischen Achse des Quarzes anlegt, dann kann eine Strommessung entsprechend dem Faraday-Effekt (siehe Schwab, A.A.O.) durchgeführt werden. Das erfindungsgemäße Korrekturverfahren ist das gleiche und hier liegt, wie sich bei Messungen ergeben hat, der Fehler des tatsächlichen Meßergebnisses im Promillebereich.

Anhand der Zeichnung, in der ein Ausführungsbeispiel der Erfindung dargestellt ist, sollen die Erfindung sowie weitere vorteilhafte Ausgestaltungen und Verbesserungen der Erfindung näher erläutert und beschrieben werden.

Es zeigen:

| | |
|---|---|
| Figur 1 | eine schematische Darstellung einer bekannten Meßeinrichtung, |
| Figur 2 | ein Strom-Zeitdiagramm, das mit der Einrichtung nach Figur 1 erfaßt worden ist, |
| Figur 3 | die Temperaturabhängigkeit des Wechselstrom- oder Wechselspannungssignales, |
| Figur 4 | eine erfindungsgemäße Meßanordnung, |
| Figur 5 | eine perspektivische Darstellung des Analysators, der in der erfindungsgemäßen Meßanordnung benutzt wird, |
| Figur 6 | die Lage der Polarisationsebenen des Analysators nach Figur 5, |
| Figur 7 | eine Strom-Winkeldarstellung, entsprechend dem Gesetz von Malus, |
| Figur 8 | die Abhängigkeit des Gleichspannungssignals über der Temperatur bei der erfindungsgemäßen Meßanordnung, |
| Figur 9 | die Temperaturabhängigkeit des Gleichstromsignales über der Temperatur, jeweils ohne Temperaturkorrektur, |
| Figur 10 | den Verlauf des Wechselstromsignals über der Temperatur bei der erfindungsgemäßen Meßanordnung, |
| Figur 11 | eine Tabelle, in der $\Delta$ DC und K für jede Temperatur (Index $_i$) aufgelistet sind, |
| Figur 12 a bis f | gemessene und errechnete Daten in Kurvendarstellung bei einem Eichlauf eines bestimmtem Quarz-Meßelementes, |
| Figur 13 a bis d | gemessene und errechnete Daten ähnlich denen der Figur 12, bei einem Korrekturlauf während einer betriebsmäßigen Messung, und |
| Figur 14 | eine graphische Darstellung der tatsächlich vorhandenen, korrigierten Sekundärspannung über der Temperatur. |

Es sei Bezug genommen auf die Figur 1.

Dort ist eine Spannungsmeßeinrichtung auf der Grundlage des Pockelseffektes dargestellt. Diese besteht im wesentlichen aus einer monochromatischen Lichtquelle 10, die als Laser, als Infrarot-Leuchtdiode und ähnliches ausgebildet ist. Das Licht der Lichtquelle 10 wird einem Polarisator 11, einem mit Elektroden 12 und 13 versehenen elektrooptischen Kristall 14, einem weiteren linearen Polarisator oder Analysator 15 zugeführt; das aus dem Analysator austretende Licht wird von einer Empfängerdiode 16 empfangen und in einem nicht näher dargestellten Meßverstärker mit nachgeschalteter Auswerteelektronik ausgewertet. Als elektrooptischer Kristall findet in dieser Anordnung entweder ein synthetischer oder natürlicher α-Quarz Verwendung.

Wie oben dargestellt, ist Quarz ein optisch einachsiges, anisotropes Medium des trigonalen Kristallsystems der Klasse 32. Der Kristall weist sowohl natürliche lineare Doppelbrechung als auch natürliche optische Aktivität (zirkulare Doppelbrechung), so daß man beobachten kann, daß sich der Polarisationszustand von einfallendem, linear polarisiertem Licht nach Verlassen des Quarzes ohne äußeres elektrisches Feld verändert hat. Man erhält im allgemeinen schwach elliptisch polarisierstes Licht. Die Wirkung beider Effekte auf einen linear polarisierten Lichtstrahl läßt sich dadurch erklären, daß dieser im Kristallinneren in zwei entgegengesetzt rotierende elliptisch polarisierende Teilwellen mit identischen Achsenverhältnissen zerlegt wird, die sich als Folge unterschiedlicher Brechungsindices mit voneinander abweichenden Phasengeschwindigkeiten im Kristall ausbreiten und sich nach dessen Verlassen wegen der nun vorhandenen relativen Phasendifferenz zwischen den beiden Teilwellen zu schwach elliptisch polarisiertem Licht überlagern.

Die durch die optische Aktivität (Index $_{OA}$) verursachte Phasendifferenz berechnet sich zu

$$\delta_{OA} = \frac{2\pi d}{\lambda_0 \bar{n}} \cdot g \qquad (1)$$

Mit

d = Länge des Lichtweges im Kristall,

$_0$ = Wellenlänge des Lichtes im Vakuum,

g = Gyrationskonstante und

n = Mittelwert von der Raumrichtung abhängiger Berechnungsindices.

Der Anteil der linearen Doppelbrechung (Index $_{LD}$) wird durch

$$\lambda_{LD} = \frac{2\pi d}{\lambda_0}(n_z - n_x)\sin^2\chi \qquad (2)$$

mit

λ = Winkel zwischen optischer Achse des Quarzes und Lichtausbreitungsrichtung und

$n_z, n_x$ = Brechungsindex parallel zur kristallographischen Z- bzw. X-Achse bestimmt.

Die zusätzliche induzierte lineare Doppelbrechung aufgrund eines elektrischen Wechselfeldes (Index $_{PO}$) bewirkt eine Pendelbewegung des schwach elliptisch polarisierten Lichtes um den Winkel um dessen Ruhelage, was mathematisch durch

$$\delta_{PO} = \frac{2\pi d}{\lambda_0}(-n^{-3} r_{11} E) \qquad (3)$$

beschrieben wird mit

n = arithmetischer Mittelwert der wirksamen Brechungsindices

$r_{11}$ = elektrooptische Konstante und

E = elektrisches Feld.

6

Die Gesamtverschiebung berechnet sich zu

$$\delta = \sqrt{\delta_{OA}^2 + (\delta_{LD} + \delta_{PO})^2} \qquad (4)$$

Die Umwandlung dieses polarisationsmodulierten Signals in ein analoges Intensitätssignal erfolgt mit dem Analysator nach dem Gesetz von Malus

$$j = j_0 \cos^2\alpha \qquad (5)$$

Mit

$j_0$ = Intensität des Lichtes vor dem Analysator

$j$ = Intensität des Lichtes nach dem Analysator

$\alpha$ = Winkel zwischen großer Halbachse des elliptisch polarisierten Lichtes und Durchlaßrichtung des Analysators.

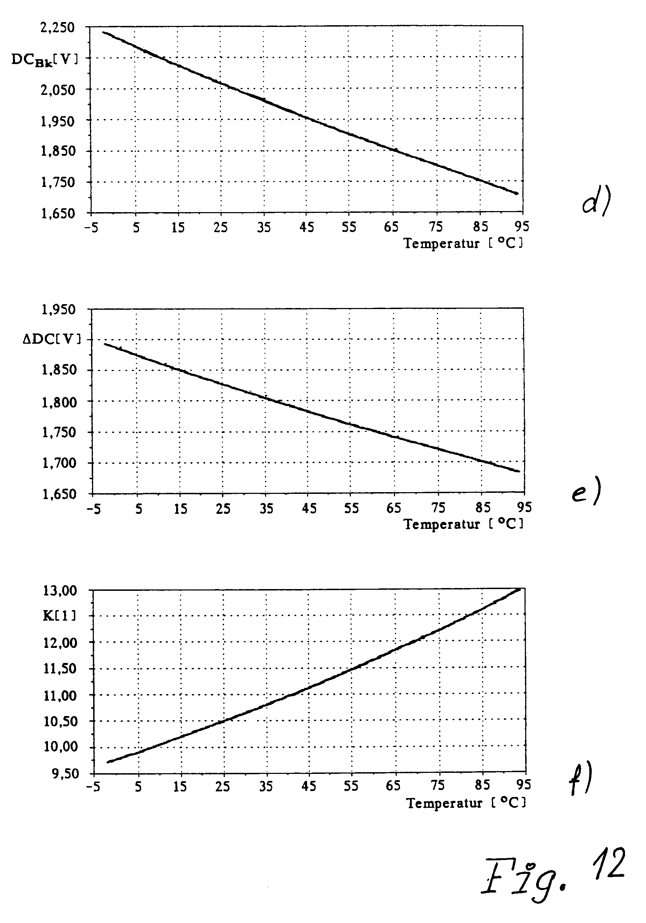

Die Intensität des Lichtes kann dann nach der Auswerteeinheit einer Stromstärke entsprechen; in der Figur 7 ist das Gesetz von Malus dargestellt. Im Bereich des Winkels 45° ist die Kurve angenähert linear und aus diesem Grunde wird der Analysator in diesem Bereich betrieben.

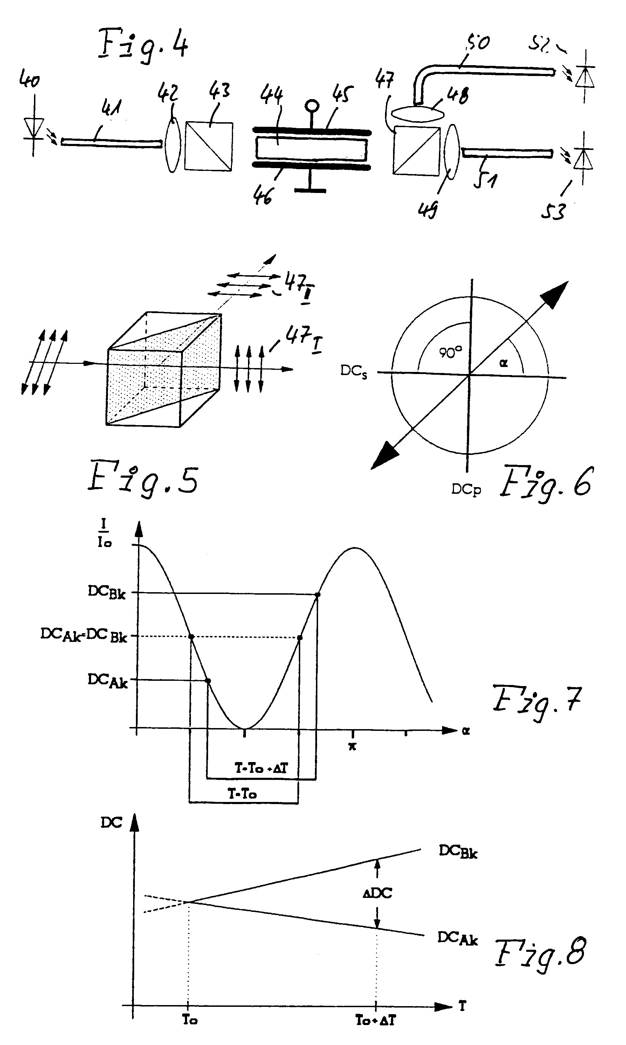

Beim Passieren der Polarisatoren 11 und 15 und dem Quarz 14 wird das Licht gedämpft und darüberhinaus, wie aus Figur 3 ersichtlich, der Wechselspannungsanteil des von der Empfängerdiode 16 empfangenen Lichtes aufgrund von Temperatureinflüssen stark temperaturabhängig. Der Wechselspannungsanteil verringert sich dabei in dem technisch genutzten Bereich um bis zu 10 %, was beispielsweise bei einer Meßspannung zwischen den beiden Elektroden 12 und 13 von 1,1 kV doch immerhin eine Differenz von 110 V darstellt. Die Temperaturänderung basiert auf einer Temperaturkoeffizienten der elektrooptischen Konstanten $r_{11}$.

Damit die Temperaturveränderung empfangsseitig korrigiert werden kann, ist zunächst eine "Bereinigung" der Signale von sog. statistischen Fehlern erforderlich.

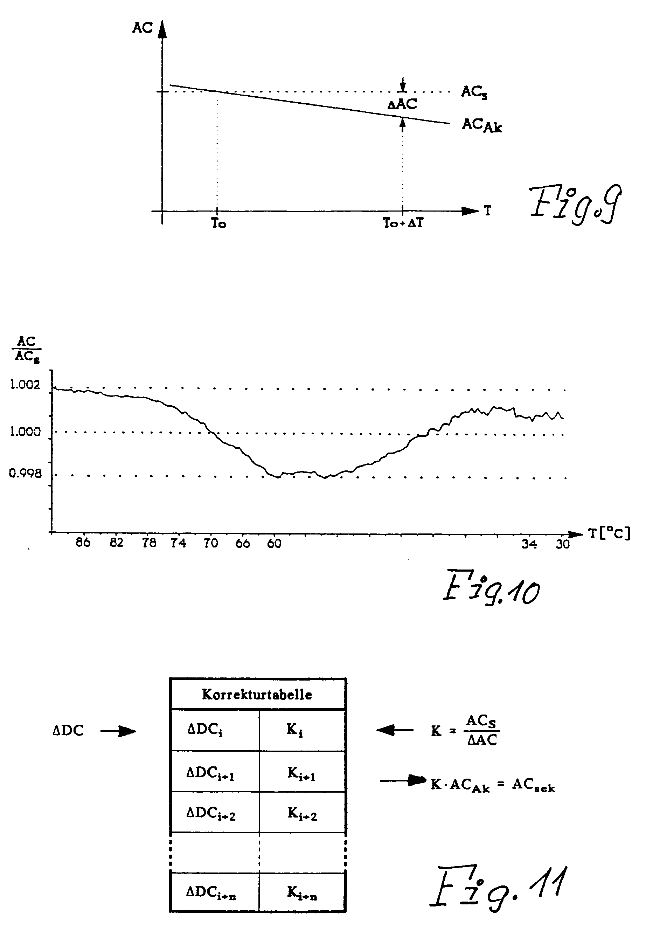

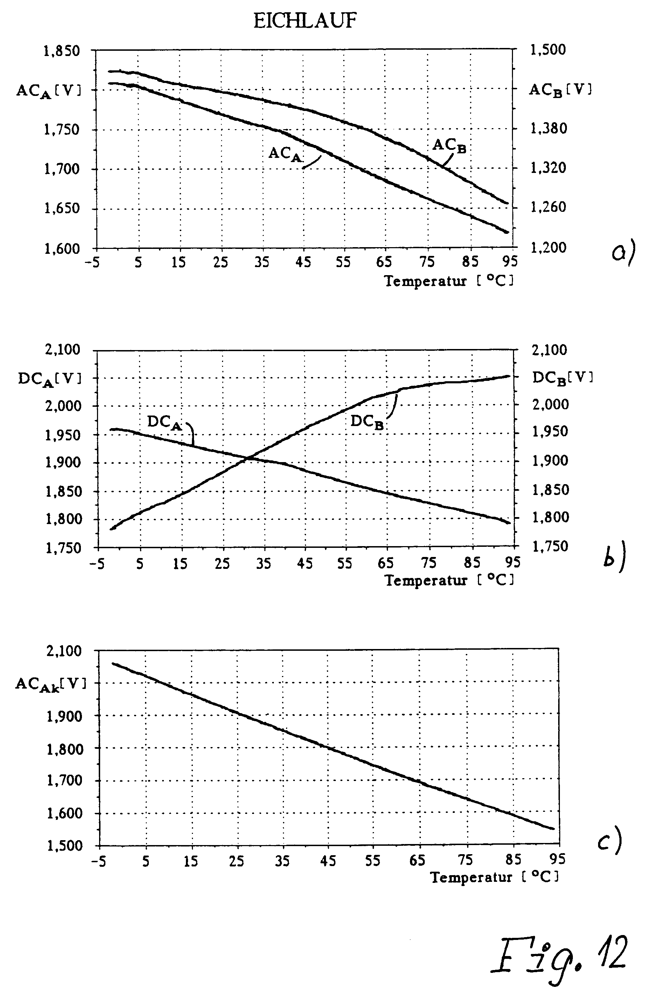

Erfindungsgemäß wird eine Anordnung nach Figur 4 benutzt. Eine näherungsweise monochromatische Lichtquelle 40 koppelt ihr Licht in einen Lichtwellenleiter 41 ein, der das Licht zu einer Linse 42 und einem daran anschließenden Polarisator 43 überträgt. Der Ausgang des Polarisators 43 wird einem elektrooptischen Quarzkristall 44 zugeführt, an dessen beiden Seiten je eine Elektrode 45 und 46 angebracht sind. Hinter dem elektrooptischen Kristall 44 befindet sich ein Analysator 47, der als polarisierter Strahlenteilerwürfel ausgebildet ist und über je eine Linse 48 bzw. 49 das polarisierte Licht über einen Lichtwellenleiter 50 bzw. 51 einem ersten Empfänger 52 bzw. einem zweiten Empfänger 53 zuführt. Das von der Lichtquelle 10 abgesendete Licht hat eine Lichtwellenlänge von $\lambda$ = 850 nm. Durch den polarisierenden Strahlenteilerwürfel 47 wird das Licht in zwei senkrecht zueinander polarisierte Teilstrahlen zerlegt, in Figur 5 durch die beiden Teilstrahlen $47_1$ und $47_2$. Diese beiden Teilstrahlen werden jeweils getrennt erfaßt.

Unter der Voraussetzung einer konstanten, am elektrooptischen Kristall 44 anliegenden Wechselspannung erhält man empfängerseitigen Ende der Lichtwellenleiter 50 und 51 beim Durchfahren eines Temperaturbereiches von 0° C bis 80° C ein Wechselspannungssignal gemäß der Kurve nach Figur 3. Man erkennt an dem gezackten Verlauf, daß diese Wechselspannung zusätzlich mit Fehlern zufälliger Natur als Folge von Dämfungseinflüssen entlang der optischen Übertragungsstrecke behaftet ist.

Um eine Korrektur vorzunehmen, ist zunächst mit der erfindungsgemäßen Meßanordnung der Fehler statistischer oder zufälliger Natur zu erfassen.

Grundsätzlich wirkt sich eine veränderte Dämpfung entlang des Lichtweges auf das Wechselspannungs- (AC) bzw. Gleichspannungssignal (DG) jedes Teilstrahles derart aus, daß das Verhältnis beider Spannungen immer konstant bleibt. Zwischen beiden Signalanteilen besteht eine vollständige Korrelation. Im Idealfall gilt: DC/AC = $DC_A/AC_A$ = $DC_B/AC_B$ = konstant (6). Hierbei ist mit dem Index "A" der Anteil der Lichtintensität an der Empfängerdiode 53 und mit dem Index "B" der Anteil bzw. der Wert an der Empfängerdiode 52 bezeichnet.

Im Realfall gilt die Gleichung (6) nicht, sondern

$DC_A/AC_A$ = konstant = $DC_B/AC_B$ = konstant (7),

da in der Praxis eine exakte Justierung der großen Halbachse des elliptisch polarisierten Lichtes nach Verlassen des Quarzes im Winkel von 45° zur Durchlaßrichtung des Analysators nie exakt möglich ist.

EP 0 410 234 B1

Wegen dieser Restelliptizität selbst in exakter 45°-Stellung werden in die Lichtwellenleiter 50 und 51 voneinander abweichende Lichtintensitäten bereits dann eingekoppelt, wenn keine Wechselspannung über dem Meßquarz 44 anliegt, wenn also $DC_A = DC_B$ gilt.

Zur Bereinigung der Meßsignale von Fehlern statistischer Natur wird in einem ersten Schritt durch Vergleich der Spannung $DC_A$ mit einem vorgegebenen Sollwert $DC_S$ ein Korrekturfaktor $C_1$ ermittelt, der wegen der beiden Gleichen (6) und (7) die Korrektur der Spannung $AC_A$ erlaubt:

$$DC_S/DC_A = C_1 \qquad (8)$$

$$AC_{AK} = C_1 \times AC_A$$

Hierin ist $AC_{AK}$ der korrigierte Wechselspannungsanteil am Empfänger 53.

Damit ist die optische Übertragungsstrecke von der Lichtquelle 40 über die Lichtwellenleiter 41 und 51 bis zur Empfangsdiode 53 von Dämpfungseinflüssen bereinigt. Der korrigierte Wechselanteil $AC_{AK}$ stellt nun den Sollwert für die in einem zweiten Schritt vorzunehmende Bereinigung der Signale $DC_B$ und $AC_B$ von äußeren, die Lichtführung von der Lichtquelle 42 entlang der Lichtwellenleiter 43 und 50 zur Empfangsdiode 52 beeinflussenden Störgrößen dar. Da direkt nach dem Analysator 47 die Effektivwerte der Wechselanteile beider Teilstrahlen identisch sind, muß dies auch für die entsprechenden empfangsseitig registrierten Werte von $AC_A$ und $AC_B$ gelten, und infolgedessen wird ähnlich wie in der obigen Gleichung (8) durch Vergleich von $AC_{AK}$ und $AC_B$ ein weiterer Faktor $C_2$ ermittelt, dessen Multiplikation mit $DC_B$ einen Wert $DC_{BK}$ ergibt:

$$AC_{AK}/AC_B = C_2$$
$$DC_{BK} = C_2 \times DC_B.$$

Bei konstanter Temperatur $T_0$ nimmt $DC_{BK}$ den Wert von $DC_S$ an (Figur 7 und 8).

Der korrigierte Wechselspannungsanteil am Empfänger 53 ist noch von der Temperatur abhängig. Der Fehler, dessen Ursache im negativen Temperaturkoeffizienten der elektrooptischen Konstanten $r_{11}$ zu suchen ist, führt zu einer Signalverfälschung. Bei Temperaturänderungen $\Delta T$ weisen jedoch auch die Gleichanteile $DC_{AK}$ und $DC_{BK}$ eine Drift auf, deren Ursache im wesentlichen in der ausgeprägten Temperaturabhängigkeit des spezifischen Drehvermögens der optischen Aktivität liegt. Die thermische Längenausdehnung in kristallographischer Z-Richtung ist bei Quarz (mit $\beta = 7{,}4 \times 10^{-6}$ 1/K, K = Grad Kelvin) minimal, so daß eine hierauf zurückzuführende Änderung des Polarisationszustandes beim Austritt des Lichtes aus dem Meßkristall 44 bzw. Meßelement 44 vernachlässigbar ist. Die natürliche lineare Doppelbrechung im Quarz ist in erster Näherung temperaturunabhängig. Unter dem Einfluß sich ändernder Temperatur ist ein Abwandern der Schwingungsebene des näherungsweise linear polarisierten Lichtes nach Verlassen des Quarzes aus seinem Arbeitspunkt, d. h. aus einem Winkel von $\alpha = 45°$ (siehe Figur 6). Zu den beiden senkrecht zueinander stehenden Durchlaßrichtungen des Analysators zu beobachten. Dabei findet, wie aus der Figur 8 ersichtlich ist, keine hälftige Aufteilung der vor dem Analysator vorhandenen Lichtintensität mehr statt, siehe Figur 7 und 8. Die Differenz $\Delta DC$ der Gleichanteile D CAK und D CBK, die in Figur 7 dargestellt ist, stehen jedoch zu jedem Zeitpunkt wegen der Reversibilität der Temperaturabhängigkeit der optischen Aktivität in einem definierten Zusammenhang mit der Temperatur längs des Lichtweges im Kristallinneren, also

$$\Delta DC = f(T) \qquad (10)$$

Und ist der ebenfalls temperaturbedingten Abweichung $\Delta AC$ des Wechselsignales $AC_{AK}$ von seinem wahren Wert $AC_S$ proportional (siehe Figur 8 und 9) und zwar nach der Gleichung

$$\Delta AC = AC_S - AC_{AK} = p \times \Delta DC \qquad (11).$$

Diese Gleichung weist einen Weg zur Korrektur von $AC_{AK}$ auf. Dazu wird der Kristall 44, der bei Raumtemperatur $T_0$ justiert wird, sich schrittweise ändernden Temperatur ausgesetzt, bis ein spezifizierter Temperaturbereich vollständig durchfahren worden ist. Während dieses Vorganges wird für jeden Temperaturschritt sowohl die Differenz $\Delta DC$ der Gleichanteile als auch die dazu gehörige Abweichung $\Delta AC$ ermittelt. Der Quotient aus $AC_S$ und $\Delta AC$ ergibt einen weiteren Korrekturfaktor K, der zusammen mit $\Delta DC$ als Wertepaar in einer Tabelle abgespeichert wird. Während des Beschreibens der Korrekturtabelle ist die über dem Meßquarz bzw. Meßkristall bzw. Meßelement 44 anliegende Hochspannung konstant zu halten. Ihr Effektiv ist bekannt und entspricht dem Sollwert $AC_S$.

8

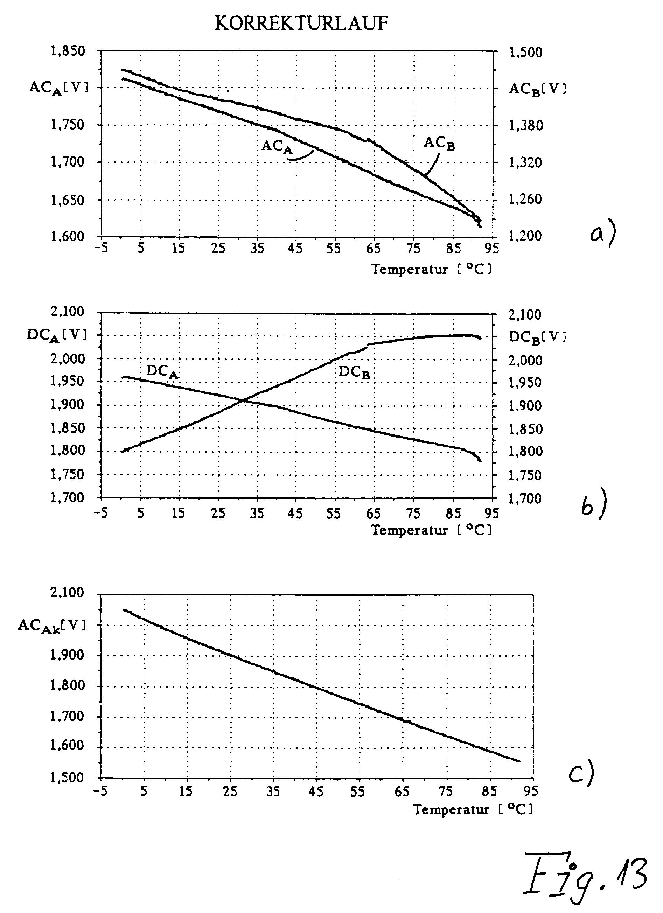

Soll der Wandler zur genauen Messung von Hochspannungen eingesetzt werden, so wird auf bekannte Art und Weise (siehe Gleichungen 6 bis 9) in periodischen Zeitabständen $\Delta$ DC aus den vier zur Verfügung stehenden Eingangsgrößen $AC_A$, $DC_A$; $AC_B$, $DC_B$ berechnet, der ermittelte Wert in der Tabelle gesucht und der dazu gehörige Korrekturfaktor K entnommen. Die Multiplikation dieses Faktors mit der zuvor berechneten Spannung $AC_{AK}$ führt auf die eigentliche Sekundärspannung $AC_{SEK}$ des Wandlers. Voraussetzung für das Funktionieren dieses Verfahrens ist, daß die Justierung des Wandlers (Figur 4) zwischen dem einmaligen Aufstellen der Korrekturtabelle und allen folgenden Meßvorgängen unverändert bleibt, d. h. die Justierung erfolgt nach der Fertigung des Wandlers. Werden die elektrischen Signale der optischen Empfänger 52 und 53 beispielsweise einem Mikrorechner zugeführt, so liegt die Korrekturtabelle als Datei vor. Die Meßwertkorrektur kann von einem Computerprogramm vorgenommen werden. Wurde ein spezifizierter Arbeitstemperaturbereich, beispielsweise von 0 bis 90° durchfahren, wobei genügend kleine Temperaturintervalle vorgesehen sind, dann erhält man eine Kurve gemäß Figur 10. Dort verläuft der Wechselspannungsanteil AC bezogen auf den Sollspannungsanteil $AC_S$ in einem Bereich zwischen 1,002 und 0,998 also in einem Bereich, der ± im Promillebereich liegt. Eine derartige Meßgenauigkeit ist für praktische Zwecke ausreichend.

Das in obiger Beschreibung dargestellte, an Quarz erprobte Verfahren kann mit einer Vielzahl elektrooptischen Materialien durchgeführt werden. Voraussetzung dafür ist, daß ein natürlicher, im elektrooptischen Kristall auftretneder Effekt eine gewisse Temperaturabhängigkeit aufweist und damit den Polarisationszustand des Lichtes nach Verlassen des Kristalls auf systematische, reproduzierbare Art und Weise beeinflussen kann. Während dieser Effekt bei $\alpha$-Quarz die Temperaturabhängigkeit der optischen Aktivität ist, kann dies beispielsweise im Falle von ADP ($NH_4H_2PO_4$) die ausgeprägte Temperaturabhängigkeit der natürlichen linearen Doppelbrechung sein, ebenso bei KDP ($KH_2PO_4$) und bei $LiNbO_3$. Treten mehrere derartige Effekte gleichzeitig in einem Kristall auf, so werden diese als Summenergebnis erfaßt. Nichtlineare Zusammenhänge von $\Delta$ DC und der Temperatur bzw. Mehrdeutigkeiten werden von diesem Verfahren, insbesondere bei Einsatz eines Mikrorechners, zur Signalkorrektur erkannt. Es ergeben sich auch keinerlei Einschränkungen hinsichtlich der Kristallänge, so daß durch dessen Variation eine Anpassung an die zu messende Hochspannung im Hinblick auf einen genügend großen Modulationsgrad, aber auch zur Verringerung der elektrischen Beanspruchung, vor allem beim longitudinalen Pockeleffekt, vorgenommen werden kann.

Die Verwendung von Quarz ist günstig, da wegen der niedrigen Dielektrizitätszahl von $Y_R$ = 4,5 eine sehr geringe "Meßwerkskapazität" erzielt werden kann. Dadurch werden Messungen auch mit geringer Rückwirkung auf die Spannungsquelle ermöglicht. Kristalle, bei denen eine natürliche optische Aktivität nicht zu erkennen ist, besitzen gleichwohl eine Temperaturabhängigkeit des Pokkelseffektes, so daß sich auch bei solchen Kristallen ein recht hoher Meßfehler einstellt. Die mit dem erfindungsgemäßen Korrekturverfahren bzw. mit der erfindungsgemäßen Korrektureinrichtung erzielte Genauigkeit liegt, wie oben dargestellt und in Figur 10 ersichtlich, in einem Temperaturbereich von 0 bis 90° bei 2 Promille.

Die Figur 11 zeigt eine Korrekturtabelle, in die beim Eichvorgang $\Delta$ DC, das ist die Differenz zwischen den beiden Gleichspannungsanteilen am ersten und am zweiten Empfänger, korrigiert um die Dämpfungseinflüsse, siehe Figur 8, eingetragen ist. Dieser Wert $\Delta$ DC mit dem Index $_i$ ist jeweils ein Korrekturfaktor $K_i$ zugefügt, wobei die einzelnen Indices einzelne bestimmte Temperaturen bedeuten. Der Korrekturfaktor $K_i$ ist zu errechnen aus dem Quotienten $AC_S/\Delta$ AC für jede einzelne Temperatur, siehe Figur 9.

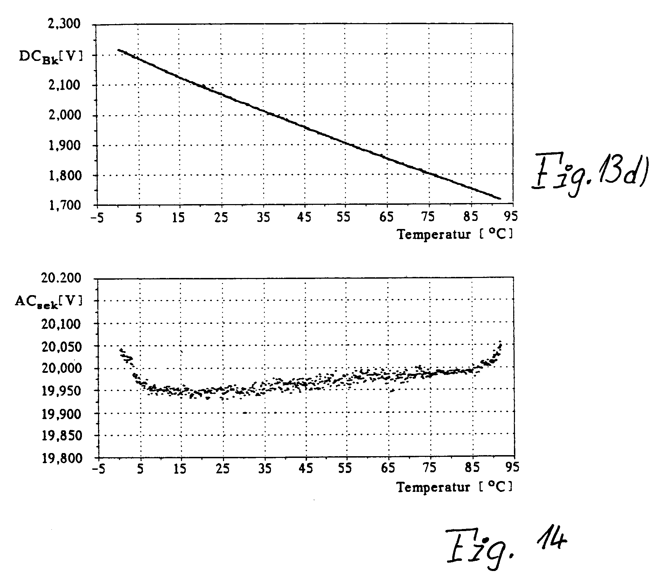

Die Figur 12a bis 12f zeigt in einzelnen graphischen Darstellungen einen Eichlauf:

In Figur 12a sind die Werte $AC_A$ und $AC_B$ über der Temperatur aufgetragen. Man erkennt hieraus, daß die beiden Werte $AC_A$ und $AC_B$ voneinander differieren.

Die Figur 12b zeigt den Temperaturverlauf der beiden Gleichspannungsanteile $DC_A$ und $DC_B$, die kreuzförmig gegeneinander gerichtet sind: während $DC_A$ mit steigender Temperatur absinkt, steigt $DC_B$ mit steigender Temperatur an. Knickstellen bei etwa 65°C sind auf besondere, im Eichvorgang liegende äußere Einflüsse zurückzuführen.

Aus den beiden Kurvenscharen Figur 12a und b errechnet sich die korrigierte Wechselspannung $AC_{AK}$; hierbei diese Wechselspannung am ersten Empfänger abgenommen.

Aus dem korrigierten Wechselspannungsanteil $AC_{AK}$ bestimmt sich der korrigierte Gleichspannungsanteil $DC_{BK}$, siehe Figur 12, gemäß oben dargestellter Gleichung und die Differenz zwischen $DC_{AK}$ und $DC_{BK}$ ist aus Figur 12e ersichtlich, aus der sich dann gemäß oben angegebener Gleichung der Korrekturfaktor K-(1), siehe Figur 12f, ermittelt. Man erkennt, daß zu jeder Temperatur ein bestimmter Korrekturfaktor K(1) existiert. Die beiden Kurven 12e und 12f sind in der Tabelle Figur 11 abgespeichert.

Die Spannungsmeßeinrichtung bzw. die Einrichtung zum Messen eines elektrischen Feldes wird nach der Herstellung einjustiert, wobei für eine ganz bestimmte Spannungs- oder Feldmeßeinrichtung die Tabelle gemäß Figur 11 bereitgestellt wird.

Wenn während des Betriebes eine Spannungsmessung durchgeführt werden soll, werden im Endeffekt zunächst die gleichen Schritte durchgeführt wie beim Eichvorgang: man mißt die beiden Wechselspannungsanteile am ersten und am zweiten Empfänger und erhält eine Kurvenschar gemäß Figur 13a. Sodann wird die Messung der Gleichspannungsanteile durchgeführt, woraus sich eine Kurvenschar gemäß Figur 13b ergibt. Mit diesen beiden Meßvorgängen wird der korrigierte Wechselspannungsanteil $AC_{AK}$ gemäß Figur 13c bestimmt und danach $DC_{BK}$ gemäß Figur 13d. Da man damit auch $DC_{AK}$ erhält, kann man $\Delta DC$ errechnen, siehe Figur 12e, und erhält hieraus zu jeder bestimmten Temperatur den Korrekturfaktor gemäß der Figur 12f. Multipliziert man mit diesem Korrekturfaktor bei bestimmten Temperaturen den Wechselspannungsanteil an dem ersten Empfänger, dann erhält man für verschiedene Meßvorgänge die Kurve gemäß Figur 14. Dabei ist an das Meßelement eine Spannung von 20 Volt angelegt worden, die konstant gehalten wird; die tatsächlich gemessene Spannung schwankt zwischen ca. 19,95 Volt und 20,05 Volt, so daß die Ungenauigkeit bei ca. 1 bis 1,5 Promille liegt.

**Patentansprüche**

1. Verfahren zur Messung einer elektrischen Spannung oder eines elektrischen Feldes, bei dem als Sensor (44) ein elektrooptischer Kristall, der von der Spannung oder dem Feld beaufschlagt und von polarisiertem Licht durchstrahlt wird, verwendet wird, und die Änderung des Polarisationszustandes des aus dem Sensor (44) austretenden Lichtes detektiert wird, wobei der aus dem Sensor (44) austretende Lichtstrahl in zwei Teilstrahlen aufgeteilt wird und die Teilstrahlen je einem Empfänger (52, 53) zugeführt werden, dadurch gekennzeichnet, daß die Teilstrahlen in jedem Empfänger (52, 53) in Spannungssignale mit je einem Gleich- und einem Wechselanteil umgewandelt werden und daß aus den Differenzen jeweils der Gleich- und wechselanteile Korrekturfaktoren zur Temperaturkorrektur der aufgrund Temperaturänderungen bewirkten Änderungen des Polarisationszustandes des aus dem Sensor (44) austretenden polarisierten Lichtes ermittelt werden und der gemessene Wechselanteil damit korrigiert wird.

2. Verfahren nach Anspruch 1, gekennzeichnet durch folgende Verfahrensschritte:
   1. Zur Korrektur von Fehlern statistischer Art wird ein erster Korrekturfaktur $C_1$ aus

   $$C_1 = DC_S/DC_A$$

   ermittelt, wobei
   $DC_S$ =    Sollwert des Gleichspannungsanteils
   $DC_A$ =    Istwert des Gleichspannungsanteils an einem ersten der beiden Empfänger
   2. Mit diesem ersten Korrekturfaktor $C_1$ werden die am ersten Empfänger erhaltenen Wechselspannungs und Gleichspannungsanteile multipliziert:

   $$C_1 \times AC_A = AC_{AK}$$
   $$C_1 \times DC_A = DC_{AK},$$

   worin
   $AC_A$ =    Wechselspannungsanteil am ersten Empfänger
   $AC_{AK}$ =    korrigierter Wechselspannungsanteil am ersten Empfänger
   $DC_{AK}$ =    korrigierter Gleichspannungsanteil am ersten Empfänger,
   3. mit $AC_{AK}$ wird ein zweiter Korrekturfaktor $C_2$ bestimmt

   $$C_2 = AC_{AK}/AC_B$$

   worin
   $AC_B$ =    Wechselspannungsanteil am zweiten Empfänger
   woraus sich ergibt

   $$DC_{BK} = C_2 \times DC_B$$

   worin
   $DC_{BK}$ =    korrigierter Gleichspannungsanteil am zweiten Empfänger
   $DC_B$ =    Gleichspannungsanteil am zweiten Empfänger.

3. Verfahren nach Anspruch 2, dadurch gekennzeichnet, daß zur Korrektur der Temperaturabhängigkeit für unterschiedliche Temperaturen und konstante Spannung die Differenz der korrigierten Gleichspannungsanteile am ersten und am zweiten Empfänger bestimmt wird nach der Gleichung:

$$\Delta DC = DC_{AK} - DC_{BK}$$

und die Differenz der Wechselspannungsanteile an den beiden Empfängern gemäß

$$AC = AC_S - AC_{AK} = p \times \Delta DC$$

ermittelt wird, worin

$AC_S$ = Sollwert der Wechselspannung

p = Proportionalitätsfaktor;

sodann ein dritter Korrekturfaktor K aus den Quotienten des Soll-Wechselanteils zu der Differenz der beiden Wechselanteile gemäß der Gleichung:

$$K = AC_S / \Delta AC$$

berechnet und für jedes $\Delta DC$ mit diesem zusammen als Wertepaar in eine Tabelle eingegeben wird.

4. Verfahren nach Anspruch 3, dadurch gekennzeichnet, daß bei betriebsmäßiger Messung die Differenz der Gleichanteile $\Delta DC$ entsprechend der jeweils herrschenden Temperatur gemessen wird und daß entsprechend dem $\Delta DC$-Wert der Korrekturfaktor K aus der Tabelle ausgelesen und damit der tatsächlich vorhandene Wechselanteil ermittelt wird nach der Gleichung:

$$AC_{AK} \times K = AC_{SEK}$$

worin

$AC_{SEK}$ = die tatsächliche sekundäre Wechselspannung darstellt.

5. Einrichtung zur Durchführung des Verfahrens nach den Ansprüchen 1 bis 4, dadurch gekennzeichnet, daß die Einrichtung einen als elektrooptischer Kristall ausgebildeten Sensor (44) aufweist, welcher zwischen zwei elektrisch leitenden Platten (45, 46) als Dielektrikum angeordnet ist, und daß an der Eingangsseite des Sensors (44) ein Polarisator (43) und an der Ausgangsseite ein als Strahlenteilerwürfel ausgebildeter Analysator (47), der das aus dem Sensor (44) austretende Licht in zwei senkrecht zueinander polarisierte Teilstrahlen zerlegt, die zwei getrennten optischen Empfängern (52, 53) zugeführt werden, vorgesehen sind.

6. Einrichtung nach Anspruch 5, dadurch gekennzeichnet, daß die Empfänger (52, 53) mit einer Auswerteeinrichtung verbunden sind, in der ein Speicher vorgesehen ist, in dem die $\Delta DC$-Werte und Temperaturwerte gemeinsam abgespeichert sind.

**Claims**

1. Method of measuring an electric voltage or an electric field, in which an electro-optic crystal is used as sensor (44), across which the voltage or field is applied and through which polarized light is passed, and in which the change in the polarization state of the light emerging from the sensor (44) is detected, the light beam emerging from the sensor (44) being divided into two sub-beams, and each of the sub-beams being fed to a receiver (52, 53), characterized in that the sub-beams in each receiver (52, 53) are converted into voltage signals, each with a DC and an AC component, and in that correction factors are determined from the differences in the respective DC and AC components, for temperature correction of the changes, caused by temperature fluctuations, in the polarization state of the polarized light emerging from the sensor (44), and in that the measured AC component is corrected in this way.

2. Method according to Claim 1, characterized by the following steps in the procedure:

1. for correcting statistical-type errors, an initial correction factor $C_1$ is determined from

$$C_1 = DC_S/DC_A$$

where

$DC_S$ = expected value for the DC voltage component

$DC_A$ = actual value of the DC voltage component at the first of the two receivers;

2. the AC and DC voltage components obtained at the first receiver are multiplied by this first correction factor $C_1$:

$$C_1 \times AC_A = AC_{AK}$$
$$C_1 \times DC_A = DC_{AK},$$

where

$AC_A$ = AC voltage component at the first receiver

$AC_{AK}$ = corrected AC voltage component at the first receiver

$DC_{AK}$ = corrected DC voltage component at the first receiver;

3. a second correction factor $C_2$ is defined using $AC_{AK}$

$$C_2 = AC_{AK}/AC_B$$

where

$AC_B$ = AC voltage component at the second receiver,

which gives

$$DC_{BK} = C_2 \times DC_B$$

where

$DC_{BK}$ = corrected DC voltage component at the second receiver

$DC_B$ = DC voltage component at the second receiver.

3. Method according to claim 2, characterized in that, for correcting the temperature dependence for various temperatures and a constant voltage, the difference between the corrected DC voltage components at the first receiver and the second receiver is given by the equation:

$$\Delta DC = DC_{AK} - DC_{BK},$$

and the difference between the AC voltage components at the two receivers is determined from

$$\Delta AC = AC_S - AC_{AK} = p \times \Delta DC$$

where

$AC_S$ = expected value for the AC voltage

$p$ = proportionality factor;

then a third correction factor K is calculated from the quotients of the expected AC component and the difference between the two AC components, given by the equation:

$$K = AC_S / \Delta AC,$$

and entered in a table together with every $\Delta DC$ value as a pair of variates.

4. Method according to Claim 3, characterized in that, as a typical measurement during operation, the difference between the DC components $\Delta DC$ is measured at the prevailing temperature, and in that the correction factor K corresponding to the $\Delta DC$ value is read out from the table, so that the actual AC component which exists is determined from the equation:

$$AC_{AK} \times K = AC_{SEK}$$

where

$AC_{SEK}$ = the actual secondary AC voltage.

12

5. Device for carrying out the procedure according to Claims 1 to 4, characterized in that the device has a sensor (44) in the form of an electro-optic crystal, which is configured as a dielectric between two electrically conducting plates (45, 46), and in that there is a polarizer (43) on the input side of the sensor (44), and an analyzer (47) in the form of a beam-splitter cube on the output side, which analyzer resolves the light emerging from the sensor (44) into two sub-beams polarised at right angles to each other, which are fed to two separate optical receivers (52, 53).

6. Device according to Claim 5, characterized in that the receivers (52, 53) are connected to an evaluation device, which contains a memory in which the Δ DC values and temperature values are stored together.

**Revendications**

1. Procédé de mesure d'une tension électrique ou d'un champ électrique, dans lequel on utilise en tant que détecteur (44) un cristal électro-optique, sur lequel agit la tension ou le champ et qui est traversé par de la lumière polarisée, et on détecte la modification de l'état de polarisation de la lumière sortant du détecteur (44), le faisceau lumineux sortant du détecteur (44) étant divisé en deux faisceaux partiels et lesdits faisceaux partiels étant envoyés respectivement à un récepteur (52, 53), caractérisé par le fait que les faisceaux partiels sont convertis dans chaque récepteur (52, 53) en signaux de tension présentant respectivement une composante continue et une composante alternative et par le fait que l'on détermine, à partir des différences respectivement des composantes continues et des composantes alternatives, des coefficients de correction en vue de la correction, en fonction de la température, des modifications de l'état de polarisation, provoquées par des variations de température, de la lumière polarisée sortant du détecteur (44) et on les utilise pour corriger la composante alternative mesurée.

2. Procédé selon la revendication 1, caractérisé par les étapes suivantes:

   1. Pour corriger des erreurs de type statistique, on détermine un premier coefficient de correction $C_1$ à partir de

   $$C_1 = DC_S/DC_A$$

   avec

   $DC_S$ = valeur recherchée de la composante de tension continue
   $DC_A$ = valeur réelle de la composante de tension continue au niveau d'un premier des deux récepteurs

   2. Les composantes de tension alternative et de tension continue obtenues au niveau du premier récepteur sont multipliées par ce premier coefficient de correction $C_1$:

   $$C_1 \times AC_A = AC_{AK}$$
   $$C_1 \times DC_A = DC_{AK}$$

   avec

   $AC_A$ = composante de tension alternative au niveau du premier récepteur
   $AC_{AK}$ = composante de tension alternative corrigée au niveau du premier récepteur
   $DC_{AK}$ = composante de tension continue corrigée au niveau du premier récepteur

   3. $AC_{AK}$ sert à déterminer un deuxième coefficient de correction $C_2$:

   $$C_2 = AC_{AK}/AC_B$$

   avec

   $AC_B$ = composante de tension alternative au niveau du second récepteur,
   ce qui donne

   $$DC_{BK} = C_2 \times DC_B$$

   avec

   $DC_{BK}$ = composante de tension continue corrigée au niveau du second récepteur
   $DC_B$ = composante de tension continue au niveau du second récepteur.

**EP 0 410 234 B1**

3. Procédé selon la revendication 2, caractérisé par le fait que, pour corriger la dépendance de la température pour des températures différentes et une tension constante, on détermine la différence entre les composantes corrigées de tension continue au niveau du premier et du second récepteur, suivant l'équation:

$$\Delta DC = DC_{AK} - DC_{BK}$$

et on détermine la différence des composantes de tension alternative au niveau des deux récepteurs suivant l'équation:

$$AC = AC_S - AC_{AK} = p \times \Delta DC$$

avec
  $AC_S$ = valeur recherchée de la tension alternative
  $p$ = coefficient de proportionnalité;
puis on calcule un troisième coefficient de correction K à partir des quotients de la composante alternative recherchée par rapport à la différence entre les deux composantes alternatives, suivant l'équation:

$$K = AC_S/\Delta AC$$

et on l'inscrit dans une table pour chaque $\Delta DC$ et conjointement avec celle-ci en tant que paire de valeurs.

4. Procédé selon la revendication 3, caractérisé par le fait que lors de la mesure en service, la différence entre les composantes continues $\Delta DC$ est mesurée en fonction de la température régnante respective et par le fait que le coefficient de correction K est sélectionné dans la table en fonction de la valeur de $\Delta DC$ et sert à déterminer la composante alternative réelle, suivant l'équation:

$$AC_{AK} \times K = AC_{SEK}$$

avec
  $AC_{SEK}$ = tension alternative secondaire réelle.

5. Dispositif pour la mise en oeuvre du procédé selon les revendications 1 à 4, caractérisé par le fait que ledit dispositif présente un détecteur (44) agencé sous la forme d'un cristal électro-optique qui est placé en tant que diélectrique entre deux plaques (45, 46) électriquement conductrices, et par le fait qu'il est prévu, côté entrée du détecteur (44), un polariseur (43) et, côté sortie, un analyseur (47) agencé sous la forme d'un cube diviseur de faisceau qui divise la lumière sortant du détecteur (44) en deux faisceaux partiels polarisés perpendiculairement l'un à l'autre, qui sont envoyés à deux récepteurs optiques (52, 53) distincts.

6. Dispositif selon la revendication 5, caractérisé par le fait que les récepteurs (52, 53) sont reliés à un dispositif de traitement comprenant une mémoire dans laquelle sont stockées ensemble les valeurs $\Delta DC$ et les valeurs de température.

14

*Fig. 1*

*Fig.2*

*Fig.3*

Fig.4

Fig.5

Fig.6

Fig.7

Fig.8

Fig. 9

Fig. 10

Fig. 11

17

## EICHLAUF

a)

b)

c)

Fig. 12

d)

e)

f)

Fig. 12

## KORREKTURLAUF

a)

b)

c)

Fig. 13

Fig. 13d)

Fig. 14